**Europäisches Patentamt**

**European Patent Office**

**Office européen des brevets**

(11) Publication number : **0 484 068 A2**

# EUROPEAN PATENT APPLICATION

(21) Application number : **91309899.2**

(51) Int. Cl.$^5$ : **C08L 71/02**

(22) Date of filing : **25.10.91**

(30) Priority : **27.10.90 JP 289606/90**

(43) Date of publication of application :
**06.05.92 Bulletin 92/19**

(84) Designated Contracting States :
**AT BE CH DE DK ES FR GB GR IT LI LU NL SE**

(71) Applicant : **Suetsugu, Masao**
**3-19-17, Hon-amanuma, Suginami-ku**
**Tokyo 167 (JP)**

(72) Inventor : **Suetsugu, Masao**
**3-19-17, Hon-amanuma, Suginami-ku**
**Tokyo 167 (JP)**

(74) Representative : **Kearney, Kevin David**
**Nicholas et al**
**KILBURN & STRODE 30 John Street**
**London, WC1N 2DD (GB)**

(54) **Thermoplastic resin composition.**

(57)   A thermoplastic resin composition which comprises a polyethylene glycol compound such as polyethylene glycol and a water soluble thermoplastic polymer compound compatible with said polyethylene glycol compound such as a polymer comprising in a side chain a tertiary nitrogen atom such as of a lactam structure such as pyrrolidone and caprolactam, a tertiary amino group and a quaternary ammonium group. This resin composition softens at a relatively low temperature and is soluble in water, and besides adheres to various materials. Thus it is particularly useful as an adhesive which can temporarily bond an article to be processed to a jig at a low temperature and can be washed off with water to remove it from the article after the processing.

**EP 0 484 068 A2**

The present invention relates to a water-soluble, low-melting thermoplastic resin composition which shows a sharp phase transition within a narrow temperature range and is excellent in workability.

This thermoplastic resin composition can effectively be used as materials for products which, if necessary, may be washed off with water, for example, such adhesives for temporarily bonding or connecting an article to be processed to a jig as used in a step for processing plastic products such as contact lens, plate-like products such as semiconductor wafers, inorganic glass products such as lens and prism, products made of magnetic substances, jewelry, precious metals and personal ornaments by cutting, polishing, lapping or the like. It can also be used as a dental material, an adhesive for temporarily assembling models, a material for plaster casts, an adhesive for tags or labels, a casting material, a protective film for temporarily protecting the surface of an article from being scratched, a masking material, an adhesive for fixing hooks or hangers on a wall, and the like.

In cutting and polishing steps of manufacture of contact lens or lapping and polishing steps of manufacture of semiconductor wafers, raw materials for contact lens or semiconductor wafers have to be temporarily bonded to jigs, and for bonding them, hot melt adhesives are often used.

It is usual that mixtures of rosins, modified rosin esters, beeswaxes and paraffins or various thermoplastic resin compositions, so-called waxes, are used as such hot melt adhesives.

However, most of these conventional hot melt adhesives are high in softening temperature or does not readily fluidify over the softening temperature, and thus is inferior in workability upon application. If the adhesives are designed to have a lower melting temperature, they are apt to be lowered in strength for gripping an article to be processed and a jig, and creep may occur during the processing step, which affects dimensional accuracy of products in case of contact lens processing.

Furthermore, these conventional adhesives are insoluble in water, and thus require a solvent or a specific mixture of inorganic chemicals in order to remove them from processed articles. (Refer to "Newest Polymer Material Technology Overview (Saishin-kobunshi-zairyo-gijutsu-souran)" published by TEC Publication Kabushiki Kaisha, (hereinafter referred to as "reference 1"), pages 269-270, and "Silicon Crystals and Doping (Sirikon-kessho-to-doping)" published by Maruzen Kabushiki Kaisha, (hereinafter referred to as "reference 2"), page 25-26.)

However, many of these solvents are dangerous in that they might cause accidents such as toxication, fire and explosion, and thus are not preferred from the viewpoints of health and safety.

In order to avoid such dangers, a large amount of Freon solvents, trichloroethane, trichloroethylene and the like have been used. However, use of such compounds has recently been regulated because of environmental problems on damage to ozone layer. And, the organic solvents and the mixtures of inorganic chemicals are not versatile because they require users to select one which does not affect qualities of an article to be processed, taking the properties of the article into account.

On the other hand, there have been known water soluble thermoplastic polymer compounds such as carboxymethyl cellulose, methyl cellulose, polyvinyl alcohol and polyvinylpyrrolidone. However, these compounds are too poor in heat fluidity to be utilized as a hot melt adhesive.

In fact, no water soluble resin composition which is soluble in water and besides exhibits workability useful as a hot melt adhesive, has been known.

The object of the present invention is to provide a thermoplastic resin composition which meets such requirements and is in particular improved in workability.

As a result of intensive research made for the above object, the present inventor has found that a thermoplastic resin composition which comprises a polyethylene glycol compound and a water soluble thermoplastic polymer compound compatible with the former compound provides a thermoplastic resin composition which is soluble in water and has desired workability.

Hitherto, no resin composition soluble in water and usable as a hot melt adhesive which fluidifies by heating within a relatively low temperature range in the vicinity of room temperature, has been known. It was a general knowledge that thermoplastic resin compositions soften and fluidify by heat gradually as temperature is elevated, and thus its rate of rigidity change to temperature change is small.

On the other hand, the present thermoplastic resin composition is featured in that its rate of rigidity change is great within a specific narrow temperature range which depends upon a kind and a concentration of the polyethylene glycol compound, and thus it reversibly fluidifies or solidifies as it is slightly heated or cooled.

That is, the present thermoplastic resin composition exhibits a state transition reversible from solid in an ordinary sense to viscous liquid and vice versa as temperature is elevated or lowered slightly in the vicinity of the softening and fluidifying temperature at which articles to be bonded can readily be attached to or detached from each other by hand.

Furthermore, the present thermoplastic resin composition is characterized in that it is soluble in water. For example, only if the present composition is made into a film of 1 mm or less in thickness and left in water, it readily dissolves and disperses in water. In addition, the present thermoplastic resin composition is soluble in alcohol.

When the present thermoplastic resin composition is used as a product such as the above-mentioned hot melt adhesive for processing articles by cutting and polishing, the greater the proportion of the polyethylene glycol compound to the composition is, the more remarkable the above-mentioned state transition of the composition is, and thus workability upon attaching or detaching an article to be processed to or from a jig is more improved, but adhesion strength between the article and the jig becomes weak. Accordingly, blending ratio of the polyethylene glycol compound and the water soluble thermoplastic polymer compound in the present composition should be properly designed taking into account balance between workability and adhesion strength required for a specific use. And, the kind of the polyethylene glycol compound should also be properly selected taking into account degree of temperature elevation upon processing of an article to be processed as well as its heat resistance.

For example, when materials for contact lens are processed, it is desired that they are readily attached to or detached from a polishing jig at a temperature of 60C or less since optical transmission distortion tends to occur in contact lens over this temperature. From this point of view, when the present composition is used as an adhesive for contact lens materials and other articles poor in heat resistance which have to be attached to or detached from a jig at 60°C or less, the present composition preferably comprises 40 - 90 % by weight of the polyethylene glycol compound and 60 - 10 % by weight of the water soluble thermoplastic polymer compound, and more preferably 50 - 80 % by weight of the former and 50 - 20 % by weight of the latter.

Further, the present composition is soluble in water, and thus it can be readily removed from jig and contact lens by washing off the composition with water. In case of conventional adhesives, removing agents such as solvents and swelling agents were required in order to remove adhesive residues from the surface of lens after cutting or polishing processes. And, when a strong removing agent was used, there was a possibility that optical transmission distortion occurred in contact lens. When a removing agent which is not so strong as to cause optical transmission distortion, for example, kerosene, was used, adhesives had to be removed by rubbing them off by a fingertip, and thus the surface of contact lens was often scratched by nails. If contact lens were finished by hand so carefully as not to scratch the surface, more time and personnel were needed. As a result, percent defective sometimes amounts to several tens in a cutting and polishing process of the manufacture of contact lens. Due to such a high percent defective, the cost of manufacture was increased, and there was a possibility that the planning of production became difficult to be made, causing problems on sales activity. However, the present composition will eliminate these problems by virtue of its water solubility.

It should, however, be noted that even if the present composition is constituted by 40 % by weight or less of the polyethylene glycol compound, it can provide an attaching and detaching workability practically acceptable for the processing of an article having heat resistance to a temperature of 60°C or more, and does not lose water solubility. In this case, the rate of change of rigidity of the present composition in the vicinity of its softening and fluidifying temperature is slightly lowered as mentioned above, but as far as articles to be processed are resistant to heat, the composition can fully achieve practical purposes.

## Water soluble thermoplastic polymer compound

The water soluble thermoplastic polymer compound compatible with the polyethylene glycol compound is a water soluble polymer compound which has, in a side chain, a tertiary nitrogen atom, more specifically, a tertiary nitrogen atom containing group which includes a lactam structure such as pyrrolidone group and a caprolactam group, a tertiary amino group and a quaternary ammonium group.

Preferably, it is a water soluble polymer compound which comprises, as a monomeric unit, a compound having in its molecular (a) a vinyl or (meth)acryloyl group and (b) a tertiary nitrogen atom such as of a lactam structure, a tertiary amino group or a quaternary ammonium group, in other words, a vinyl or (meth)acryl monomer which has a lactam structure such as pyrrolidone and caprolactam, a tertiary amino group or quaternary ammonium group.

Examples of the vinyl or (meth)acryl monomer having a lactam structure are N-vinyl-2-pyrrolidone, N-(meth)acryloxyalkyl-2-pyrrolidone, and N-vinylcaprolactam.

Examples of the vinyl or (meth)acryl monomer having a tertiary amino or quaternary ammonium group are monomers derived from acrylamides such as N,N-dialkyl(meth)acrylamide such as N,N-dimethylacrylamide and N,N-diethylacrylamide; and N,N-dialkylaminoalkyl(meth)acrylamide and salts thereof such as N,N-dimethylaminoethylacrylamide, N,N-dimethylaminopropylacrylamide, N,N-dimethylaminopropylmethacrylamide, and N,N-dimethylaminopropylacrylamide methylchloride quaternary salt; and dialkylaminoalkyl(meth)acrylates and salts thereof such as diethylaminoethylacrylate, dimethylaminoethylacrylate methylchloride quaternary salt, and diethylaminoethylmethacrylate.

More preferably, the water soluble thermoplastic polymer compound is one which comprises, as a monomeric unit, a vinyl or (meth)acryl monomer having a lactam structure such as N-vinyl-2-pyrrolidone, N-(meth)acryloxyalkyl-2-pyrrolidone and N-virylcaprolactam, or a N,N-dialkyl(meth)acrylamide monomer such as N,N-dimethylacrylamide and N,N-diethylacrylamide, since these compounds are superior in compatibility with polyethylene glycol. Among them, especially preferred is a polymer compound having in its side chain a pyrrolidone group, for example, a polymer comprising as a monomeric unit a vinyl or (meth)acryl monomer having a pyrrolidone group such as N-vinyl-2-pyrrolidone and N-(meth)acryloxyalkyl-2-pyrrolidone.

The water soluble thermoplastic polymer compound used in the present invention can be obtained by polymerizing at least one kind of the above-mentioned monomeric compounds in an ordinary process. The polymer compound may be a copolymer of an above-mentioned monomeric compound and another copolymerizable comonomer. As the copolymerizable comonomer, preferred are vinyl acetate and ethyl acrylate. However, it is desirable that the above-mentioned monomeric unit constitutes 30 % by weight or more, preferably 40 - 100 % by weight of the water soluble thermoplastic polymer compound, from the view point of water solubility of the present composition.

Molecular weight of the water soluble thermoplastic polymer compound used in the present invention has no special limitation. However, generally speaking, the larger the average molecular weight of the polymer compound is, the greater the breaking strength becomes, but workability upon application is deteriorated due to high melt viscosity. Conversely, the smaller the average molecular weight is, the better the workability becomes when the composition is softened or fluidified, but the breaking strength is deteriorated. Consequently, the range of the average molecular weight of the water soluble polymeric compound is naturally limited for a practical use. Adhesives normally require constituent polymers to have a higher molecular weight to attain a higher mechanical strength as long as possible. However, the present composition employs a water soluble polymer compound having a molecular weight lower than that required by normal adhesives, but still shows an acceptable mechanical strength. In the present invention, it would be desirable that the water soluble thermoplastic polymer compound has a molecular weight of 80,000 or less, preferably 50,000 or less, more preferably 40,000 or less in terms of weight average molecular weight, and 40,000 or less, preferably 800-40,000, more preferably 1,000-20,000, most preferably 1,000-10,000 in terms of number average molecular weight.

Homopolymers of vinyl pyrrolidone can be prepared in accordance with a process shown in, for example, Takayuki OHTSU and Masaetu KINOSHITA, "Experimental Methods of Polymer Syntheses (Koubunshi-gousei-no-jikken-hou)", page 141 published by Kagakudohjin Co., or NAKAMURA, "Water Soluble Polymers (Suiyousei-koubunshi)", page 294 published by Kagakukogyo Co. Also, homopolymers of vinyl pyrrolidone are commercially supplied by BASF under the tradename of "Luviskol".

Various copolymers of vinyl pyrrolidone can be prepared for selected uses in accordance with methods disclosed in the United States Patent Nos. 2,667,473 and 2,958,614 and United Kingdom Patent No. 805,386, which are incorporated herein by reference.

It goes without saying that the skilled in the art would readily prepare copolymers of vinyl pyrrolidone with other copolymerizable compounds with reference to the above mentioned references and the like. Further, copolymers of vinyl pyrrolidone and vinyl acetate are commercially supplied by BASF under the tradename of "Luviskol" with various copolymerizing ratios.

In the present thermoplastic resin composition, the water soluble thermoplastic polymer compound may comprise only one of the above-mentioned homopolymers and copolymers, or a mixture of two or more of the above-mentioned homopolymers and copolymers.

Polyethylene glycol compound

The polyethylene glycol compound used in the present invention should be understood in a broad sense, and thus includes not only polyethylene glycol of various molecular weights but also low molecular weight compounds such as diethylene glycol, triethylene glycol, ethylene glycol dimethylethers and ethylene glycol monobutylethers.

Among them, polyethylene glycol is preferred from the viewpoint of balance between softening and fluidizing properties and adhesion. It is desirable to use polyethylene glycol having a molecular weight of 20,000 or less, preferably 10,000 or less, since the greater the molecular weight of polyethylene glycol is, the lower the heat-fluidity of the composition is. As polyethylene glycol, may be used one or two or more selected from various products supplied by Nippon Soda Co., Ltd. such as NISSO polyethylene glycol #200 (solidifying point: -50°C), #300 (solidifying point: -13°C), #400 (solidifying point: 6°C), #600 (solidifying point: 20.3°C), #1000 (solidifying point: 36 - 40°C), #1500 (solidifying point: 38 - 41°C), #1540 (solidifying point: 43 - 47°C), #2000 (solidifying point: 47 - 53°C), #4000 (solidifying point: 53 - 56°C) and #6000 (solidifying point: 56 - 61°C), a similar product line of Lion Corp., Nippon Oil & Fats Co., Ltd. and others, depending upon a specific use and its required properties.

When polyethylene glycol is used, the present composition sharply exhibits a conspicuous state transition reversible from solid in an ordinary sense to viscous liquid and vice versa as the temperature of the composition goes up and down within a specific narrow rage. This is why it is advantageous to use polyethylene glycol for applications which require such a conspicuous solidifying and softening property, for example, in hot melt adhesives.

Further, the softening/fluidifying temperature of the present composition varies depending upon solidifying point of polyethylene glycol in use. Thus, it is possible to design a resin composition having a softening/fluidifying temperature desired for a specific use by appropriately selecting a type of polyethylene glycol. For applications to hot melt adhesives and the like, it is desirable to use a polyethylene glycol having a solidifying point of about 15°C or more, preferably about 20°C or more.

Blending ratio

In the present thermoplastic resin composition, the higher the concentration of the polyethylene glycol compound is, the greater the rate of rigidity change to temperature change becomes, and the composition is more readily fluidized by a slight temperature elevation from the softening/fluidifying temperature. It is, therefore, possible to freely design the blending ratio of the polyethylene glycol compound in the present composition for various use and purposes.

For example, in case of an application to hot melt adhesives or the like, the higher the concentration of the polyethylene glycol compound is, the better the workability is when a processed article is detached from or attached to a jig, but its adhesion or gripping strength tends to deteriorate, thus, for adhesives or other applications which require good workability, the blending ratio of the polyethylene glycol and the water soluble thermoplastic polymeric compound is preferably in the amount that the former is 90-40 % by weight and the latter is 10-60 % by weight, more preferably in the amount that the former is 80-50 % by weight and the latter is 20-50 % by weight. When the present composition comprises at least 40 % by weight of polyethylene glycol, it shows a transition from solid to viscous liquid and vice versa thereby possessing a noticeable softening and fluidifying point, and thus shows sharp rigidity change as temperature is elevated or lowered within a narrow range in the vicinity of a solidifying point of the polyethylene glycol. This phenomena can be most effectively exhibited when the present composition comprises more than 50 % of polyethylene glycol.

On the other hand, when a hot melt adhesive used for adhesion of an article which is so heat-resistant as to be heated to a temperature of over 60°C during processing, is prepared, the blending ratio may be in the amount that the polyethylene glycol compound is 40 % by weight or less and the water soluble polymer compound is 60 % by weight or more. In this case, the rate of rigidity change to temperature change in the vicinity of the softening /fluidifying temperature of the present composition is lowered. Yet the composition can be sufficiently used as a hot meld adhesive for heat-resistant articles and its water solubility is not lost, and thus its practical purpose can be sufficiently attained.

Further, when the polyethylene glycol compound comprises a first polyethylene glycol compound and a second polyethylene glycol compound having a solidifying point lower than the first polyethylene glycol compound, the resulting composition maintains substantially the same softening/fluidifying temperature as the composition containing the first polyethylene glycol compound only, but shows a viscosity lower than the latter composition over the softening/fluidifying temperature. In this case, it is advantageous that the second polyethylene glycol compound is one having a solidifying point lower than the first polyethylene glycol compound by 60 °C at most, preferably, 3-40 °C, and that the second polyethylene glycol compound constitutes about 77 % by weight or less of the total of the polyethylene glycol compound. As above, the combined use of polyethylene glycol compounds having different solidifying points is effective to provide the resulting composition with workability suitable to such a specific use as an adhesive.

To the present thermoplastic resin composition comprising the above-mentioned two components, may be added an additive, for example, a coloring agent such as a pigment, a filler or a reinforcing material, if necessary.

Process for preparation

The present thermoplastic resin composition can be prepared by uniformly melting and/or blending the polyethylene glycol compound and the water soluble thermoplastic polymer compound at a required blending ratio by use of various means.

Concrete examples are a process which comprises melting and mixing a ready-made water soluble thermoplastic polymer compound and a ready-made polyethylene glycol compound, if necessary under heated condition (hereinafter referred to as "process by melting"), and a process wherein monomers which are expected to be constituents of the water soluble thermoplastic polymeric compound are solution-polymerized using the polyethylene glycol compound as a solvent (hereinafter referred to as "process by polymerizing"). The process by polymerizing is especially advantageous in that the present thermoplastic resin composition can be obtained at the termination of the polymerization reaction, and thus a step for purification of water soluble thermoplastic polymer compounds, which has been required when the polymer compounds are separately prepared, is eliminated with simplification of manufacturing process and energy conservation.

It is needless to say that any technical means which are apparent to the skilled in the art of solution polymerization, for example, regulation of molecular weight, component distribution and the like of produced polymers, can be freely utilized in the above-mentioned process by polymerizing.

## Method for use

When the present resin composition is used as an adhesive, the following two methods are useful: a first method which comprises applying the composition in solid or molten state to a jig or an article to be processed without addition of any diluting solvent and bonding them at a predetermined temperature with or without pressing, and a second method which comprises adding to the composition a solvent such as water or alcohol to obtain an adhesive solution, applying the solution to a jig or an article to be processed, volatilizing the solvent, and bonding them at a predetermined temperature with or without pressing. The present composition can be readily heated to a predetermined temperature by hot air, for example, using a hand hairdryer when a small article is to be processed.

Furthermore, the present composition which contains polyethylene glycol, is easy to be dielectrically heated, and so when an article to be processed is also easy to be dielectrically heated, the composition may be heated and molten by dielectric-heating, thereby allowing heat energy to be saved.

For example, in a step of polishing semiconductor wafers, when wafers are affixed with a wax onto a jig called a plate or a polishing table made of a material having a large heat capacity such as ceramic, the jig has been heated to 120-160°C, as disclosed in Japanese Patent Publication (Kokoku) No.1-40072.

According to the present invention, a wafer can be fixed with the present composition onto a jig by pressing the wafer to the jig together with dielectric heating after the present composition has been applied to the wafer and dried. Dielectric heating may be conducted by either high-frequency dielectric heating or microwave dielectric heating as described in "Application of High-Frequency to the Industry (Koushuha-no-kogyo-heno-ouyou)" published by Tokyo Denki University Press, pages 156-157. As a result, heat energy required for heating jigs can be saved, time required for cooling jigs after wafers have been fixed can be shortened, equipment required for heating, pressing and cooling can be simplified, and space of workshop may also be reduced.

## Brief Explanation of the Drawing

Figure 1 is a diagrammatical perspective view which explains a test specimen for adhesion test (1) employed in the following examples and comparative examples.

Figure 2 (a) and (b) are respectively a diagrammatical side view in section and a diagrammatical plan view which explain adhesion test (1) employed in the following examples and comparative examples.

Figure 3(a), (b) and (c) are diagrammatical side views which explain adhesion tests (2)-(4) employed in the following examples and comparative examples.

Figure 4 (a) and (b) are diagrammatical side views which explain peeling test employed in Example 16 shown below.

Figures 5 to 10 are pictures which show the time-course results of Example 23.

Figure 11 is diagrammatical front and side views which explain the experiment conducted to obtain Figures 12-14.

Figure 12 is a graph which shows the results of Example 24.

Figure 13 is a graph which shows the results of Example 25.

Figure 14 is a graph which shows the results of Comparative Example 4.

Hereinafter, the present invention is illustrated, but not limited, by the following examples.

## Examples 1-8

Polyethylene glycol and homopolymer or copolymer of vinyl pyrrolidone shown in Table 1 were uniformly molten and blended at blending ratios shown in Table 1 to obtain compositions.

The obtained compositions were each excellent in water solubility.

Further, the compositions were named adhesives A - H, and they were subjected to measurement of detachable temperature and the following adhesion test (1):

Adhesion test (1)

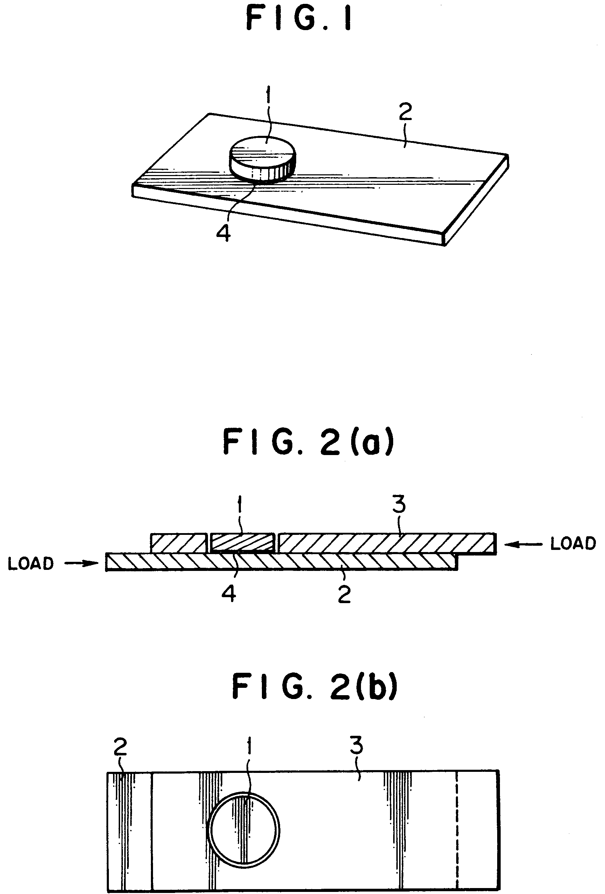

As shown in Figure 1, various materials 1 for contact lens generally called "button" (refer to page 270 of the above reference 1) having a diameter of 12 mm and a thickness of 5 mm were each fixed to each an iron plate 2 made of SPCC by use of an adhesive 4, to obtain test specimens.

A compressive shear breaking stress was measured at a temperature of 25, 35 and 45°C by covering a test specimen with an iron plate 3 which was made of the same material as the iron plate 2 and had a hole receiving the button as shown in Figure 2, and then increasing load in the direction shown by arrows in Figure 2.

The results are shown in Table 1.

Example 9

Nine (9) grams of NISSO polyethylene glycol #1000 made by Nippon Soda Co. Ltd., 8 grams of N-vinyl-2-pyrrolidone made by GAF Co., 2 grams of vinyl acetate made by Denki Kagaku Kogyo K.K. and 0.04 gram of azobisisobutylonitrile made by Nippon Hydrazine Kogyo K.K. were charged to a glass test tube of 18 mm in diameter. Then, the glass tube was heated for 10 hours in total (4 hours at 60°C, 2 hours at 70°C and 2 hours at 90°C in a water bath, and 2 hours at 110°C in an air bath) until polymerization reaction was terminated, and then the mixture was cooled to room temperature to obtain a composition. At the early stage of the polymerization reaction, the test tube was shaken sufficiently to mix molten polyethylene glycol and the other materials uniformly.

The obtained composition was excellent in water solubility.

The composition was named an adhesive J, and its detachable temperature and adhesion were measured in the same manner as in Example 1.

The results are shown in Table 2.

Example 10

Example 9 was repeated to obtain a composition except that 4 grams of NISSO polyethylene glycol #1000 and 6 grams of NISSO polyethylene glycol #1540 were used in place of 9 grams of NISSO polyethylene glycol #1000, and 5 grams of vinyl pyrrolidone and 5 grams of vinyl acetate were used.

The obtained composition was excellent in water solubility.

The composition was named an adhesive K, and its detachable temperature and adhesion were measured in the same manner as in Example 1.

The results are shown in Table 2.

Example 11

Example 9 was repeated to obtain a composition except that 12 grams of NISSO polyethylene glycol #1540 was used in place of 9 grams of NISSO polyethylene glycol #1000, and 3 grams of vinyl pyrrolidone and 7 grams of vinyl acetate were used.

The obtained composition was excellent in water solubility.

The composition was named an adhesive L, and its detachable temperature and adhesion were measured in the same manner as in Example 1.

The results are shown in Table 2.

Example 12

Example 9 was repeated to obtain a composition except that 10 grams of NISSO polyethylene glycol #1540 was used in place of 9 grams of NISSO polyethylene glycol #1000, 5 grams of N-vinylcaprolactam made by BASF was used in place of N-vinyl-2-pyrrolidone and vinyl acetate, and 0.02 gram of azobisisobutylonitrile was used.

The obtained composition was excellent in water solubility.

The composition was named an adhesive M, and its detachable temperature and adhesion were measured in the same manner as in Example 1.

The results are shown in Table 2.

Example 13

Example 9 was repeated to obtain a composition except that 9 grams of NISSO polyethylene glycol #1540 was used in place of 9 grams of NISSO polyethylene glycol #1000, 3 grams of dimethylacrylamide made by Kabushiki Kaisha Kojin was used in place of N-vinyl-2-pyrrolidone, and 0.02 grams of azobisisobutylonitrile was used.

The obtained composition was excellent in water solubility.

The composition was named as adhesive N, and its detachable temperature and adhesion were measured in the same manner as in Example 1.

The results are shown in Table 2.

Example 14

The adhesion test (1) was conducted using the adhesive A and the button made of polymethylmethacrylate (PMMA) in the same manner as in Example 1 except that an inorganic glass plate was used as a plate 2 in place of the iron plate. Adhesion strength of the adhesive A was 26 kg at 25°C.

The above adhesion test was repeated except that a brass plate was used as a plate 2 in place of the inorganic glass plate. Its adhesion strength was comparable with that to the iron plate.

The above adhesion test was repeated except that the combination of plate 2 and adhesive 4 was changed as shown below. The results are also shown below:

| Plate | Adhesive | Adhesive strength |
|---|---|---|
| Polymethylmethacrylate | Adhesive A | 25 kg |
| Vinyl chloride | Adhesive L | 10 kg |
| Polystyrene | Adhesive J | 11 kg |
| ABS resin | Adhesive A | 12 kg |

Comparative Example 1

The adhesive test (1) was conducted in the same manner as in Example 1 except that an adhesive which was supplied by City Crown Co. and commonly used to process materials for contact lens, was used as an adhesive. This test revealed that the adhesion strength was 4 kg at 25°C and 8 kg at 35°C.

When this adhesive was molten, it was greater in viscosity than the present composition and inferior in workability to the present composition. Its detachable temperature was 45 - 50°C. In addition, this adhesive was not soluble in water.

EP 0 484 068 A2

Table 1

| Ex-ample | Adhesive | Blending ratio (Part by weight) | | | | | | Detachable temperature °C | Adhesion strength (kg) (to iron plate) | | | | | | |
|---|---|---|---|---|---|---|---|---|---|---|---|---|---|---|---|
| | | | | | | | | | Button=PMMA | | | Button=LD40 | | Button=LDF50 | |
| | | VA64 | K30 | #1000 | #1540 | #2000 | #4000 | | 25°C | 35°C | 45°C | 25°C | 35°C | 25°C | 35°C |
| 1 | A | 18 | – | 15 | – | – | – | 43 | 16 | 15 | – | 14 | 15 | 16 | 15 |
| 2 | B | 10 | – | – | 10 | – | – | 50 | 12 | 15 | creep | 13 | 13 | 12 | 14 |
| 3 | C | 10 | – | – | 15 | – | – | 50 | 11 | 13 | creep | 11 | 14 | 10 | 15 |
| 4 | D | 10 | – | 2 | 8 | – | – | 50 | 14 | 15 | creep | 13 | 14 | 14 | 14 |
| 5 | E | 10 | – | – | – | 10 | – | 55 | 10 | 15 | creep | – | – | – | – |
| 6 | F | 10 | – | 4 | – | 7 | – | 55 | 12 | 14 | creep | – | – | – | – |
| 7 | G | 10 | – | 4 | – | – | 8 | 58 | 12 | 16 | 15 | – | – | – | – |
| 8 | H | – | 10 | 15 | – | – | – | 46 | 10 | 13 | – | 10 | 11 | 10 | 12 |

Notes      VA64:    Luviskol VA64 manufactured by BASF (Powdery product of vinyl pyrrolidone/ vinyl acetate: 60/40)

K30:    Luviskol K30 manufactured by BASF (Powdery product of vinyl pyrrolidone homopolymer)

#1000, 1540, 2000, 4000:   NISSO polyethylene glycol #1000, 1540, 2000, 4000 (manufactured by Nippon Soda Co., Ltd.)

Button=PMMA:    Polymethylmethacrylate button
Button=LD40:    LD40 (button made of polymethyl-methacrylate/silicone copolymer material manufactured by Lamda Optical Limited)
Button=LDF50:   LDF50 (button made of fluoro-carbon/silicone/acrylate material manufactured by Lamda Optical Limited)

Detachable temperature measured was a temperature at which the plate and the button of the test specimen for adhesion test (Figure 1) could readily be attached to or detached from each other by hand.

Table 2

| Ex-ample | Adhesive | Composition (Part by weight) | | | | | | | Detach-able temper-ature °C | Adhesion strength (kg) (to iron plate) | | | | | | |
|---|---|---|---|---|---|---|---|---|---|---|---|---|---|---|---|---|
| | | VP | VCL | DMAA | VAc | #1000 | #1540 | AIBN | | Button=PMMA | | | Button=LD40 | | Button=LDF50 | |
| | | | | | | | | | | 25°C | 35°C | 45°C | 25°C | 35°C | 25°C | 35°C |
| 9 | J | 8 | – | – | 2 | 9 | – | 0.04 | 43 | 13 | 14 | – | 14 | 13 | 14 | 14 |
| 10 | K | 5 | – | – | 5 | 4 | 6 | 0.04 | 50 | 14 | 15 | creep | 13 | 15 | 15 | 14 |
| 11 | L | 3 | – | – | 7 | – | 12 | 0.04 | 48 | 15 | 14 | creep | 13 | 14 | 12 | 15 |
| 12 | M | – | 5 | – | – | – | 10 | 0.02 | 48 | 12 | 13 | creep | 13 | 13 | 14 | 12 |
| 13 | N | – | – | 3 | 2 | – | 9 | 0.02 | 48 | 14 | 14 | creep | 13 | 14 | 13 | 12 |

EP 0 484 068 A2

Notes

VP: Vinyl pyrrolidone

VAc: Vinyl acetate

VCL: N-vinylcaprolactam

DMAA: Dimethylacrylamide

#1000, 1540: NISSO polyethylene glycol #1000, 1540
(manufactured by Nippon Soda Co., Ltd.)

AIBN: Azobisisobutylonitrile

Button=PMMA: Polymethylmethacrylate button

Button=LD40: LD40 (button made of polymethylmeth-
acrylate/silicone copolymer material manufactured
by Lamda Optical Limited)

Button=LDF50: LDF50 (button made of fluorocarbon/
silicone/acrylate material manufactured by
Lamda Optical Limited)

Detachable temperature measured was a temperature at
which the plate and the button of the test
specimen for adhesion test (Figure 1) could
readily be attached to or detached from each
other by hand.

In the following examples, the present composition was prepared as hot melt adhesives for bonding semiconductor wafers.

Adhesion performances of the adhesives prepared below were evaluated by the following test methods.

Adhesion test (2)

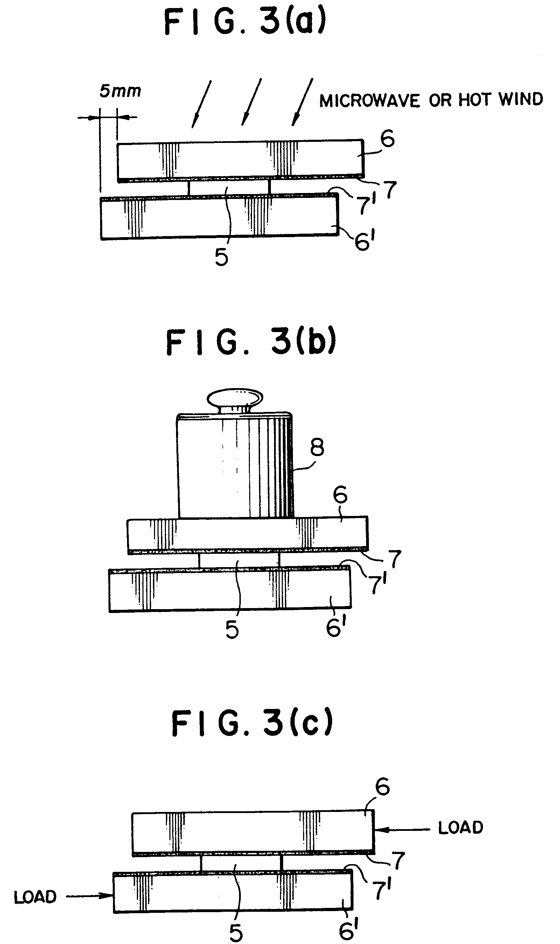

A solid adhesive was applied in a thickness of 4 - 5 microns on one side each of two ceramic plates 6 and 6' (20 X 30 X 5 (m/m)) which have been heated to 120°C in a hot air drying apparatus. As shown in Figure 3 (a), a silicon wafer 5 (10 X 10 (m/m)) was put between the adhesive coats 7 and 7' on the ceramic plates 6 and 6'. The assembly was heated for 10 minutes in a hot air drying apparatus at 120°C, and then immediately a 20-gram balance weight 8 was put onto the ceramic plate 6 as shown in Figure 3 (b). The assembly was allowed to cool to room temperature with the load of the balance weight 8, and the weight 8 was then removed from the plate 6 to obtain a test specimen.

A compressive shear breaking stress at 25°C and yield values of plastic flow at different temperatures of the adhesive were measured by applying a load to the test specimen in the direction shown by arrows in Figure 3 (c). Also, a temperature of the adhesive at which the ceramic plate and the silicon wafer of the test specimen can readily be attached to or detached from each other by hand pressure (hereinafter referred to as "detachable temperature"), was measured.

Adhesion test (3)

An adhesive solution was applied in a thickness of 20 microns on one side each of two ceramic plates 6 and 6' (20 X 30 X 5 (m/m)), dried in a hot air drying apparatus at 100°C for 10 minutes and then allowed to cool to room temperature.

As shown in Figure 3 (a), a silicon wafer 5 (10 X 10 (m/m)) was put between the adhesion coats 7 and 7' on the ceramic plates 6 and 6'. The assembly was heated for 10 minutes in a hot air drying apparatus at 120°C, and thereafter a 20-gram balance weight 8 was immediately put onto the ceramic plate 6 as shown in Figure 3 (b). The assembly was allowed to cool to room temperature, and the weight 8 was then removed from the plate 6 to obtain a test specimen.

A compressive shear breaking stress at 25°C and yield values of plastic flow at different temperatures of the adhesive were measured by applying a load to the test specimen in the direction shown by arrows in Figure 3 (c). Also, detachable temperature was measured.

Adhesion test (4)

A test specimen was obtained in the same manner as in adhesion test (3) except that the assembly shown in Figure 3 (a) was subjected to microwave for 15 seconds in a microwave oven ER-225 manufactured by Toshiba Corp. (equivalent to high frequency of 200 watts) in place of the heating of the assembly in the hot air drying apparatus, and then a 20-gram balance weight was immediately put onto the ceramic plate 6 as shown in Figure 3 (b) and was removed after 2 minutes.

A compressive shear breaking stress, yield values of plastic flow at different temperatures, and detachable temperature of the adhesive were measured in the same manner as in adhesion test (3).

Example 15

Ten (10) grams of Luviskol VA64, 10 grams of NISSO polyethylene glycol #2000 and 3 grams of NISSO polyethylene glycol #6000 were molten and blended uniformly to obtain a composition. This composition was excellent in water solubility. It was named a solid adhesive S-1.

Adhesion performances of this adhesive S-1 were evaluated in accordance with adhesion test (2). The results were shown in Table 3.

Example 16

Ten (10) grams of the solid adhesive S-1 obtained in Example 15 was dissolved in 30 grams of methyl alcohol to obtain an adhesive solution S-2.

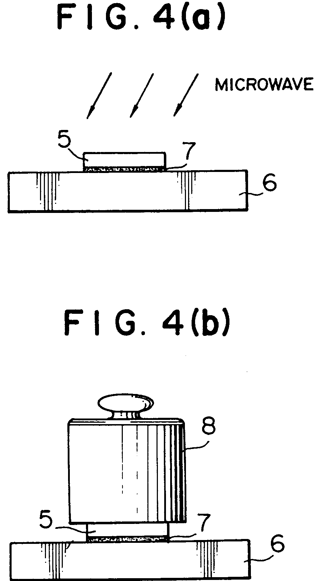

This adhesive solution S-2 was applied in a thickness of 20 microns to one side of a silicon wafer (10 X 10 (m/m)), and dried for 10 minutes in a hot air drying apparatus at 100°C and then cooled to room temperature. As shown in Figure 4 (a), the silicon wafer 5 was put on a ceramic plate 6 (20 X 30 X 5(m/m)), facing the dried adhesive coat 7 downwards. The assembly was subjected to microwave for 10 seconds in a microwave oven ER-225 manufactured by Toshiba Corp. (equivalent to high frequency of 200 watts). Thereafter, a 20-gram balance weight 8 was immediately put on a silicon wafer 5 as shown in Figure 4 (b), and removed after 2 minutes. As a result, the silicon wafer 5 tightly adhered to the ceramic plate 6, and when the silicon wafer 5 was peeled from the ceramic plate 6 by hitting an edge of the silicon wafer with a razor blade (peeling test), adhesive failure between the adhesive layer 7 and the ceramic plate 6 or the silicon wafer 5 and cohesive failure in the adhesive layer 7 were both observed.

Adhesion performances of this adhesive were evaluated in accordance with adhesive tests (3) and (4). The results are shown in Table 3. This adhesive could be readily washed off from silicon wafers with water.

Example 17

Ten (10) grams of Luviskol VA64 and 4 grams of NISSO polyethylene glycol #1000 were dissolved in 42 grams of methyl alcohol to obtain an adhesive solution S-3.

Adhesion performances of this adhesive were evaluated in accordance with adhesive test (4). The results are shown in Table 3. This adhesive could be readily washed off from silicon wafers with water.

Example 18

Ten (10) grams of Luviskol VA64 and 3 grams of NISSO polyethylene glycol #400 were dissolved in 39 grams of methyl alcohol to obtain an adhesive solution S-4.

Adhesion performances of this adhesive were evaluated in accordance with adhesive test (3). The results are shown in Table 3. This adhesive could be readily washed off from silicon wafers with water.

### Reference example 1

Four hundred (400) grams of dimethylacrylamide and 100 grams of ethyl acrylate were dissolved at room temperature in 400 grams of anhydrous ethyl alcohol in a 2-liter flask equipped with a stirrer, a reflux condenser and a thermometer. Then, the inside of the flask was purged with nitrogen gas, and the inner temperature of the flask was elevated to the boiling point of ethyl alcohol. Then, polymerization reaction was effected while 0.5 gram of azobisisobutylonitrile was added four times at intervals of one hour. The mixture was allowed to cool to room temperature one hour after the last addition of azobisisobutylonitrile, to obtain a solution (A) in ethyl alcohol of a copolymer of dimethylacrylamide and ethyl acrylate.

To this solution (A), was added 1100 grams of methyl alcohol to obtain an adhesive solution T (solid content: 25%).

As shown in Table 3, this adhesive T was not soften even at 120°C, and thus could not serve as an adhesive at 120°C or lower. However, the adhesive T was excellent in water solubility.

### Example 19

Eighteen (18) grams of a 25 % solution in methyl alcohol of NISSO polyethylene glycol #2000 made by Nippon Soda Co., Ltd. was added to 50 grams of the solution (A), and was blended and dissolved therein, to obtain an adhesive S-5.

Adhesion performances of this adhesive S-5 were evaluated in accordance with the adhesion test (3). The results were shown in Table 3. This adhesive S-5 could readily be washed off from the silicon wafer with water.

### Comparative Example 2

Adhesion performance of SKYWAX M-1, which was commercially supplied as an adhesive for bonding silicon wafers and plates in semiconductor-polishing process by Nikka Seikoh K.K. (hereinafter referred to as "adhesive U-2"), were evaluated in accordance with the adhesion test (2). The results are shown in Table 3. This adhesive U-2 was insoluble in water.

### Comparative Example 3

An adhesive solution U-3 was prepared by dissolving 25 grams of the above mentioned SKYWAX in 75 grams of trichloroethane.

Adhesion performances of the adhesive U-3 were evaluated in accordance with the adhesion test (3). The results are shown in Table 3. This adhesive was insoluble in water.

Table 3

| Example | Adhesive | | Shear breaking stress $(kg/cm^2)$ 25°C | Plastic flow yield value $(g/cm^2)$ | | | | Detachable temperature (°C) | Number of adhesion test used* |
|---|---|---|---|---|---|---|---|---|---|
| | Type | PEG ratio | | 56°C | 60°C | 70°C | 80°C | | |
| 15 | S-1 | 56% | 37 | 500> | 20> | 10> | – | 60 | (2) |
| 16 | S-2<br>S-2 | 56%<br>56% | 38<br>41 | 500><br>500> | 20><br>20> | 10><br>10> | –<br>– | 60<br>60 | (3)<br>(4) |
| 17 | S-3 | 29% | 35 | 1000> | 1000> | 100> | – | 100 | (4) |
| 18 | S-4 | 23% | 30 | – | – | 1000> | 500> | 120 | (3) |
| 19 | S-5 | 26% | 32 | – | – | – | 1000> | 120 | (3) |
| Reference Example 1 | T | – | – | – | – | – | – | Impossible at 120°C | – |
| Comparative Example 2 | U-2 | – | 28 | 50 > | 10 > | 5> | – | 58 | (2) |
| Comparative Example 3 | U-3 | – | 26 | 50 > | 10 > | 5> | – | 58 | (3) |

EP 0 484 068 A2

Note 1  PEG ratio (%) = (amount of polyethylene glycol)/
((amount of polyethylene glycol) + (water soluble
thermoplastic polymer compound)) x 100

Note 2  *:  Adhesion test (2) = (coating solid adhesive →
dry with hot air → heating with hot air →
cooling at room temperature)

Adhesion test (3) = (coating adhesive solution
→ dry with hot air → heating with hot air →
cooling at room temperature)

Adhesion test (4) = (coating adhesive solution
→ dry with hot air → heating with microwave
→ cooling at room temperature)

Note 3  Detachable temperature measured was a temperature
at which the ceramic plate and the silicon
water of the test specimen for adhesion test
(Figure 3) could readily be attached to or
detached from each other by hand.

<u>Examples 20-22</u>

Polyethylene glycol and copolymer of vinyl pyrrolidone shown in Table 4 were uniformly molten and blended at blending ratios shown in Table 4 to obtain compositions.

The obtained compositions were each excellent in water solubility.

Further, the compositions were subjected to the following workability test as adhesives:

<u>Workability test</u>

As shown in Figure 1, a material 1 for contact lens generally called "button" (refer to page 270 of the above reference 1), which was made of polymethylmethacrylate and had a diameter of 12 mm and a thickness of 5 mm, was fixed to an iron plate 2 made of SPCC by use of an adhesive, to obtain a workability test specimen.

Plastic flow yield values were measured at given temperatures by covering a test specimen with an iron plate 3 which was made of the same material as the iron plate 2 and had a hole receiving the button as shown in Figure 2, and then increasing load in the direction shown by arrows in Figure 2.

Also, detachable temperatures of these adhesives were measured.

The results are shown in Table 4.

Table 4

| Example | Composition (part by weight) | | | PEG in the system (%) | Amount of #2000 per total PEG in the system (%) | Plastic flow yield value $(gr/cm^2)$ | | | | Detachable temperature (°C) |
|---|---|---|---|---|---|---|---|---|---|---|
| | VA64 | #6000 | #2000 | | | 56°C | 58°C | 60°C | 70°C | |
| 20 | 10 | 16 | - | 62 | 0 | 1000> | 500> | 50> | 20> | 60 |
| 21 | 10 | 4 | 12 | 62 | 75 | 500> | - | 20> | 10> | 60 |
| 22 | 10 | 10 | 14 | 70 | 58 | 500> | - | 10> | 10> | 60 |

Note:  VA64: Luviskol VA64 manufactured by BASF (Powdery product of vinyl pyrrolidone/vinyl acetate: 60/40)
#6000, #2000: NISSO polyethylene glycol #6000, #2000 (manufactured by Nippon Soda Co., Ltd.)
PEG: polyethylene glycol

Detachable temperature measured was a temperature at which the plate and the buttom of the test specimen for adhesion test (Figure 1) could readily be attached to or detached from each other by hand.

EP 0 484 068 A2

Examples 23

Relationship between PEG ratio and water solubility

Composition A was prepared by uniformly melting and blending 45.5 parts by weight of NISSO polyethylene glycol #1000 (having a number average molecular weight of 1000 and manufactured by Nippon Soda Co., Ltd.) and 54.5 parts by weight of Luviskol VA64 (a vinyl pyrrolidone/vinyl acetate copolymer manufactured by BASF and having a vinyl pyrrolidone to vinyl acetate weight ratio of 60:40 and a K value of 26.6).

Composition B was prepared in the same manner as mentioned above except NISSO polyethylene glycol #1000 and Luviskol VA64 were employed in amounts of 29 parts by weight and 71 parts by weight, respectively.

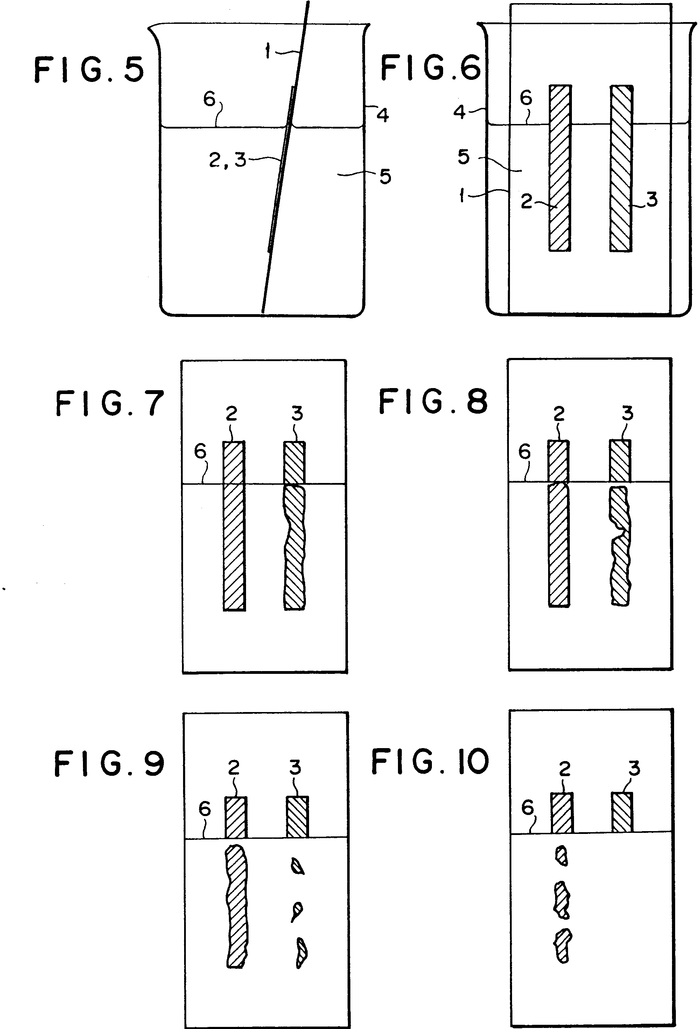

Compositions A and B were applied to a glass plate of 80 mm in width and 160 mm in length in the form of parallel strips of 10 mm in width, 80 mm in length and 1 mm in thickness, and the resultant glass plate was stood in tap water (20°C) contained in a 1-liter glass beaker of 10 cm in diameter without any agitation except natural convection, as shown in Figures 5 and 6 attached. Then, water solubility of Compositions A and B was observed.

The results are also shown in Figures 5 to 10.

Figure 5 is a side view of the glass plate just put in water contained in the beaker, Figure 6 is a front view of Figure 5, Figure 7 is a front view of the glass plate 10 minutes after it was put in water, Figure 8 is a front view of the glass plate 20 minutes after it was put in water, Figure 9 is a front view of the glass plate 30 minutes after it was put in water, and Figure 10 is a front view of the glass plate 40 minutes after it was put in water.

In Figure 5 to 10, the numeral 1 denotes the glass plate, the numeral 2 denotes Composition B, the numeral 3 denotes Composition A, the numeral 4 denotes the beaker, the numeral 5 denotes water, and the numeral 6 denotes the surface of water.

As shown in these Figures, Composition A, which had a PEG ratio of 40 % or more, was completely dissolved in water in 40 minutes, while it took more than 1 hour for Composition B, which had a PEG ratio (29%), to completely degrade in water.

Example 24

Relationship between PEG ratio and state transition (I)

Compositions I to VI were prepared by uniformly melting and blending the same NISSO polyethylene glycol #1000 (PEG #1000) and Luviskol VA64 as used in Example 23, at the ratios shown in Table 5.

Table 5

|  | Composition ratio | |
|  | PEG #1000 | Luviskol VA64 |
| Composition I | 29 % | 71 % |
| Composition II | 35 % | 65 % |
| Composition III | 40 % | 60 % |
| Composition IV | 42 % | 58 % |
| Composition V | 45 % | 55 % |
| Composition VI | 50 % | 50 % |

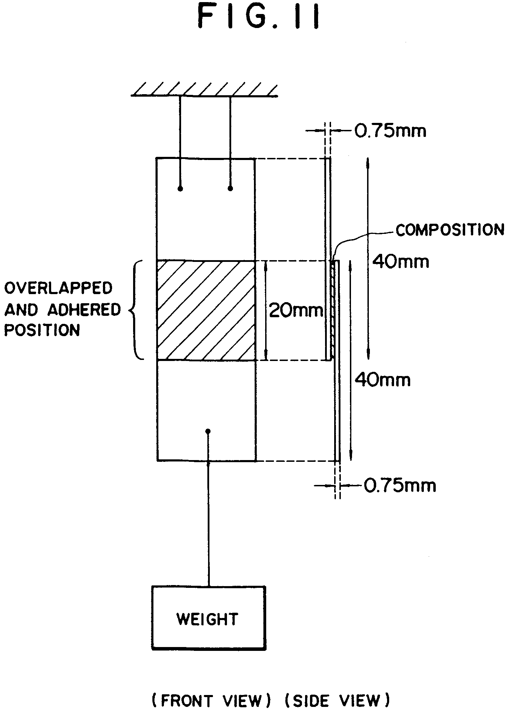

As shown in Figure 11, two polished steel plate having 20 mm in width, 40 mm in length and 0.75 mm in thickness were adhered to each other by use of each of Compositions I to VI, and one end of the adhered plates was hanged from a fixed support in a hot air chamber at 15°C while a weight was hanged from the other end

18

of the adhered plates. Then, temperature in the hot air chamber was elevated by 1°C every 1 minute. Temperature at which the two plates began to translate relative to one another was recorded, and the weight was determined as a yield value (unit: g/cm²) of compositions at that temperature.

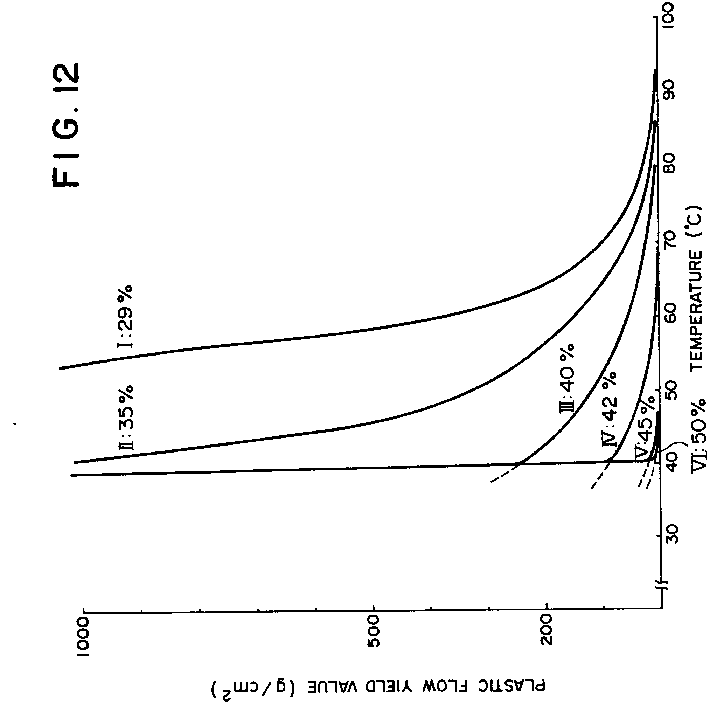

Curves indicated by full line in Figure 12 were obtained by repeating the above procedure using various weight.

It is understood from Figure 12 that Compositions III, IV, V and VI having a PEG #1000 ratio of at least 40 % sharply fluidized at about 40°C which is in the vicinity of the solidifying temperature of PEG #1000, and thus a PEG ratio of at least 40 % is critical for workability of the compositions.

It is assumed that this sharp state transition of the compositions having a PEG #1000 ratio of 40 % or more, particularly, the maintenance of rigidity at up to 40 °C, is thanks to filler-like function of microfine particles of excessive PEG present in the system whilst such curves as indicated by broken lines in Figure 12 would be expected if a plasticizer which does not produce such microfine particles in the system is used in place of PEG.

Also, it is apparent from Figure 12 that Composition III, IV, V and VI of PEG ratios of 40 % or more can be fluidized within a temperature range which is quite lower and narrower than Compositions I and II of PEG ratios of 29% and 35%.

Also, it is notable that Composition VI having a PEG ratio of 50 % showed very sharp state transition and thus would be useful to be spread on articles to be processed through a dispenser in an automated process for manufacture of silicon wafers and so on.

Example 25

Relationship between PEG ratio and state transition (II)

Compositions VII and VIII were prepared by uniformly melting and blending NISSO polyethylene glycol #2000 (PEG #2000) and the same Luviskol VA64 as used in Example 23, at the ratios shown in Table 6.

Table 6

|  | Composition ratio | |
|---|---|---|
|  | PEG #2000 | Luviskol VA64 |
| Composition VII | 40 % | 60 % |
| Composition VIII | 50 % | 50 % |

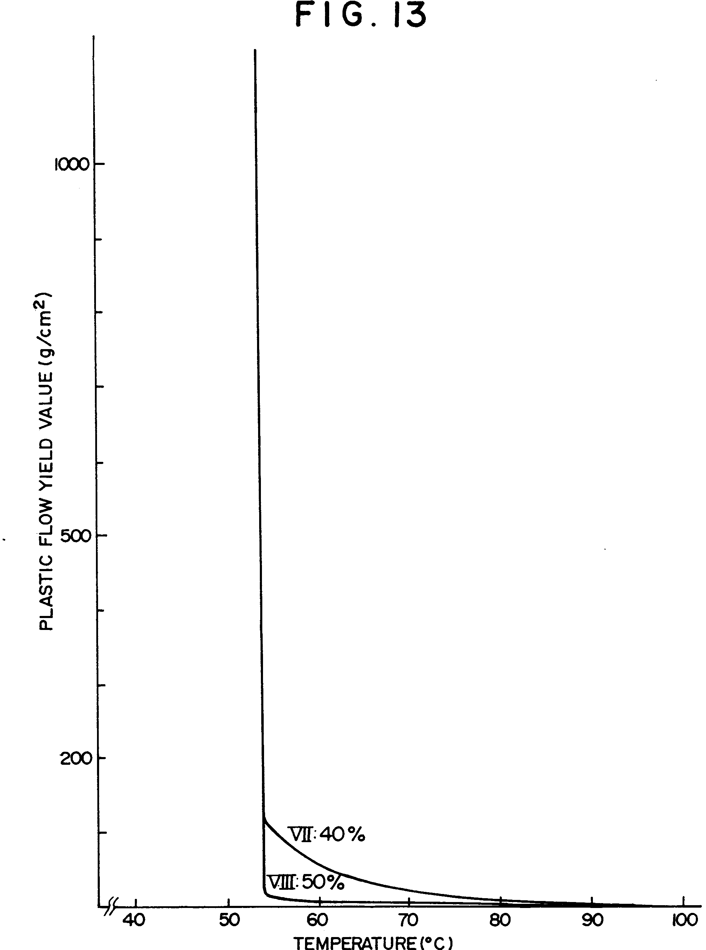

Curves indicated by full lines in Figure 13 were obtained for Compositions VII and VIII in the same manner as in Example 24.

It is understood from Figure 13 that compositions which show a state transition similar to Example 24 can be obtained by use of NISSO polyethylene glycol #2000.

Comparative Example 4

Compositions IX, X, XI and XII were prepared by uniformly melting and blending the same Luviskol VA64 as used in Example 23 with glycerol or triacetin, at the ratios shown in Table 7.

Table 7

| | Composition ratio | | |
|---|---|---|---|
| | Glycerol | Triacetin | Luviskol VA64 |
| Composition IX | 40 % | – | 60 % |
| Composition X | 50 % | – | 50 % |
| Composition XI | – | 40 % | 60 % |
| Composition XII | – | 45 % | 55 % |

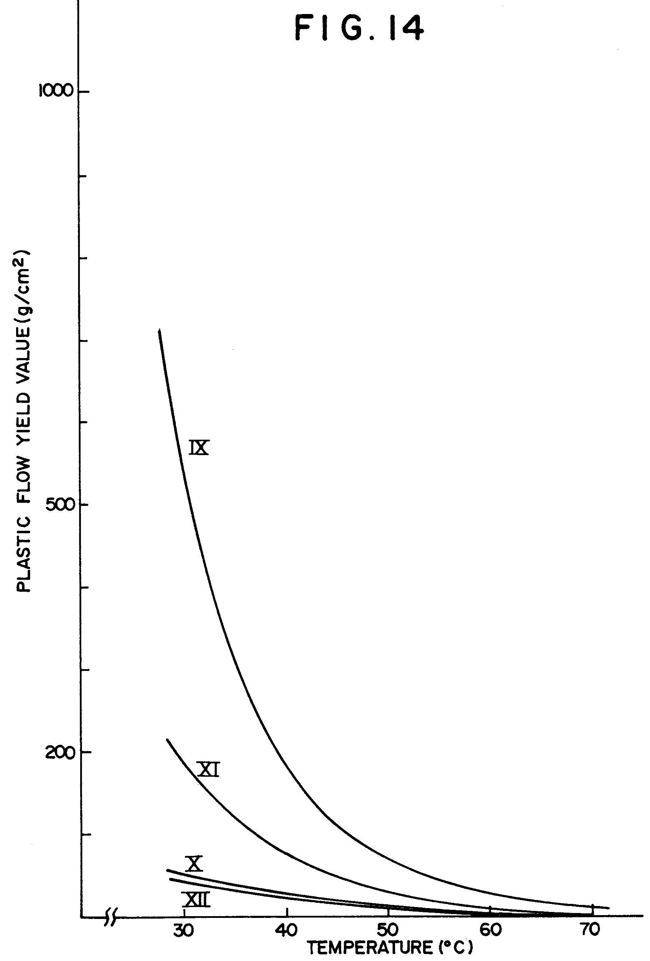

Curves indicated by full lines in Figure 14 were obtained for Compositions IX to XII in the same manner as in Example 24.

It is understood from Figure 14 that none of Compositions IX to XI showed a sharp state transition.

From the above, it is understood that the present thermoplastic resin composition has excellent thermoplasticity and water solubility, and by virtue of these properties, can be applied to a wide rage of uses.

In addition, the present thermoplastic resin composition has excellent adhesion to various materials such as of glass, metal and plastic, and is superior in adhesion strength to the conventional adhesives that have been used with up to about 10 kg of adhesion strength in contact lens cutting and polishing processes. Thus, the present composition is practically usable without any problem for this purpose. Also, the present thermoplastic resin composition is superior in adhesion strength to the conventional bonding agents that have been used in semiconductor wafer polishing and cutting processes.

Further, as shown in Examples 21 and 22, if a first polyethylene glycol compound is used in the present composition in combination with a second polyethylene glycol compound having a solidifying point lower than the first polyethylene glycol compound, the resultant composition shows a much lower viscosity over its softening/fluidifying temperature and thus quite excellent workability is obtained.

Furthermore, the present thermoplastic resin composition is soluble in water, and thus can be washed off with water from contact lens with no concern about injuring the surface of contact lens which has been finished by cutting and polishing. The present resin composition is, therefore, suitable as a material for hot melt adhesives for use in the cutting and polishing process for contact lens. Moreover, the present composition can be designed to have a low softening and fluidifying temperature, and thus can be applied to optically and physiologically high performance plastic contact lens materials to which conventional adhesives could not be applied.

Furthermore, the present thermoplastic resin composition can be used not only as a hot melt adhesive but also in the form of a solution in a solvent such as an alcohol since it is also soluble in alcohol, and thus requires no harmful solvent.

In addition, because the present thermoplastic resin composition is easy to be dielectric-heated, adhesion to articles such as semiconductor wafers and precious metals can readily be performed using induction heating.

Moreover, the present thermoplastic resin composition is readily dissolved and dispersed in water. Therefore, the present thermoplastic resin composition can be used as a material for various other products which are expected to be washed off with water for some purposes.

It should be noted that it is apparent that the present thermoplastic resin composition can be applied to various uses and objects, but since the formulation of each composition which meets the requirements suited to each use and object depends upon a lot of interrelated factors, it is, herein, impossible to provide the formulation of each composition which is applied to each use and object. Yet, because it would be easy for the skilled in the art to prepare a composition for each use and object and to examine or confirm its effects with reference to the present specification, it should be construed that any of such a composition be included in the present invention.

**Claims**

1. A water soluble thermoplastic resin composition consisting essentially of at least 40 % by weight of polyethylene glycol and at most 60 % by weight of a water soluble thermoplastic polymer,

   wherein said water soluble thermoplastic polymer comprises a polymer made from at least one monomer selected from the group consisting of vinyl, acryloyl and methacryloyl monomers wherein at least one selected monomer has a structure selected from the group consisting of a lactam structure, a tertiary amino structure and a quaternary ammonium structure, and has a number average molecular weight of 40,000 or less,

   wherein said polyethylene glycol has a solidifying point of at most 61°C.

2. The thermoplastic resin composition of claim 1, which has a plastic yield value of at most 20 g/cm$^2$ at 70°C.

3. The thermoplastic resin composition of claim 2, which exhibits such a state transition that plastic flow yield value is lowered by over 450 g/cm$^2$ as temperature of the composition is elevated by 4 °C.

4. The thermoplastic resin composition of claim 1, which consists essentially of at least 50 % by weight of polyethylene glycol and at most 50 % by weight of a water soluble thermoplastic polymer.

5. The thermoplastic resin composition of claim 1 wherein said monomer having said structure comprises at least 30% by weight of said water soluble thermoplastic polymer.

6. A thermoplastic resin composition according to claim 1, in which said lactam structure is selected from the group consisting of a pyrrolidone structure and a caprolactam structure.

7. A thermoplastic resin composition according to claim 1, in which said monomer is selected from the group consisting of N-vinyl-2-pyrrolidone, N-acryloxyalkyl-2-pyrrolidone, N-methacryloxyalkyl-2-pyrrolidone, N-vinylcaprolactam, N,N-dialkylacrylamide and N,N-dialkylmethacrylamide.

8. A thermoplastic resin composition according to claim 7, in which said monomer is selected from the group consisting of N-vinyl-2-pyrrolidone, N-acryloxyalkyl-2-pyrrolidone, N-methacryloxyalkyl-2-pyrrolidone and N-vinylcaprolactam.

9. A thermoplastic resin composition according to claim 1, in which said polyethylene glycol comprises a first polyethylene glycol and a second polyethylene glycol which has a solidifying point lower than that of the first polyethylene glycol.

10. A hot melt adhesive which comprises a thermoplastic resin composition defined in claim 1.

11. A process for preparing a thermoplastic resin composition defined in claim 1, which comprises polymerizing said at least one monomer in a polyethylene glycol solvent.

12. A method of processing an article by polishing, grinding or cutting comprising the steps of

   contacting an article selected from the group consisting of a contact lens and a semiconductor wafer with a thermoplastic resin composition comprising a polyethylene glycol compound and a water soluble thermoplastic polymer compound compatible with said polyethylene glycol compound, and with an apparatus for processing said article,

   bonding said article to said apparatus by heating said composition to about the detachable temperature thereof and cooling said composition to a temperature at which said article cannot be readily detached from said apparatus,

   and processing said article by polishing, grinding or cutting.

13. The method of claim 12 wherein in said contacting article, said article is a contact lens.

14. The method of claim 12 wherein in said contacting an article, said article is a semiconductor wafer.

15. The method of claim 14 wherein said heating during said bonding step is accomplished using dielectric heating.

# F I G. I

# F I G. 2 (a)

LOAD →

← LOAD

# F I G. 2(b)

# F I G. 3(a)

5mm

MICROWAVE OR HOT WIND

6

7

7'

6'

5

# F I G. 3(b)

8

6

7

7'

5

6'

# F I G. 3(c)

6

LOAD

7

7'

LOAD

5

6'

# F I G. 4(a)

MICROWAVE

# F I G. 4(b)

FIG.5

FIG.6

FIG.7

FIG.8

FIG.9

FIG.10

# F I G. 11

OVERLAPPED AND ADHERED POSITION

0.75mm

COMPOSITION

40mm

20mm

40mm

0.75mm

WEIGHT

(FRONT VIEW) (SIDE VIEW)

# FIG. 12

# F I G. 13

# F I G . 14